# EUROPÄISCHE PATENTSCHRIFT

(11) **EP 2 341 354 B1**
(45) Veröffentlichungstag und Bekanntmachung des Hinweises auf die Patenterteilung: **21.03.2012**
(21) Anmeldenummer: 11002225.8
(22) Anmeldetag: 24.07.2008
(51) Int. Cl.: G01R 31/304, G01R 27/32

(54) **Kontaktloses Messsystem**
Contactless measuring system
Système de mesure sans contact

(30) Priorität: 03.08.2007 DE 202007010784 U
(43) Veröffentlichungstag der Anmeldung: 06.07.2011
(62) Teilanmeldung aus: 08785051.7
(73) Patentinhaber: Rosenberger Hochfrequenztechnik GmbH & Co. KG, 83413 Fridolfing (DE)
(72) Erfinder: Zelder, Thomas, 21337 Lüneburg (DE)
(74) Vertreter: Kandlbinder, Markus Christian

(56) Entgegenhaltungen:
- WO-A-94/08248
- US-A1- 2003 011 380
- YHLAND ET AL: "An In-Circuit Noncontacting Measurement Method for S-Parameters and Power in Planar Circuits", ROWAVE THEORY AND TECHNIQUES, IEEE SERVICE CENTER, PISCATAWAY, NJ, US, Bd. 49, Nr. 12, 1. Dezember 2001 (2001-12-01), XP011038538, ISSN: 0018-9480

## Beschreibung

Die Erfindung betrifft ein Kalibriersubstrat für ein kontaktloses Messsystem, mit wenigstens einer Messspitze, die einen Teil einer Koppelstruktur zum kontaktlosen Auskoppeln eines auf einem Signal-Wellenleiter laufenden Signals ausbildet, wobei auf dem Kalibriersubstrat wenigstens ein Kalibrierelement, insbesondere Kurzschluss-Standard, Leerlauf-Standard, Widerstands-Standard, Leitungs-Standard, ausgebildet ist, wobei das wenigstens eine Kalibrierelement elektrisch mit wenigstens einem Signal-Wellenleiter, insbesondere Mikrostreifenleitung oder Koplanarleitung, verbunden ist, gemäß dem Oberbegriff des Anspruchs 1.

Die Bestimmung von Streuparametern von innerhalb einer komplexen Schaltung eingebetteten elektrischen Bauteilen mittels einer kontaktlosen Vektornetzwerkanalyse ist beispielsweise aus T. Zelder, H. Eul, "Contactless network analysis with improved dynamic range using diversity calibration", Proceedings of the 36th European Microwave Conference, Manchester, UK, Seiten 478 bis 481, September 2006 oder T. Zelder, H. Rabe, H. Eul, "Contactless electromagnetic measuring System using conventional calibration algorithms to determine scattering parameters", Advances in Radio Science - Kleinheubacher Berichte 2006, Band 5, 2007 bekannt. Im Vergleich zum herkömmlichen kontaktbehafteten Netzwerkanalyseverfahren werden die internen Richtkoppler eines Netzwerkanalysators durch kontaktlose Nahfeldmesssonden ersetzt, die direkt mit den vektoriellen Messstellen des Analysators verbunden sind. Die Messsonden werden über den Signalleitungen des Messobjektes positioniert. Die Sonden können dabei induktiv und/oder kapazitiv auf das elektromagnetische Feld der planaren Leitung wirken. Um die Streuparameter zu messen, werden herkömmliche Kalibrierverfahren verwendet, wie sie auch bei der kontaktbehafteten Netzwerkanalyse zur Anwendung kommen.

Bei der kontaktlosen Vektornetzwerkanalyse wird für jedes Messtor eines unbekannten Testobjektes (DUT - Device Under Test) mindestens eine Messsonde, wie beispielsweise eine Leiterschleifen oder zwei kapazitive Sonden, benötigt. Aus F. De Groote, J. Verspecht, C. Tsironis, D. Barataud and J.-P. Teyssier, "An improved coupling method for time domain load-pull measurements", European Microwave Conference, Band 1, Seiten 4ff, Oktober 2005 ist es beispielsweise bekannt, kontaktlose Leiterschleifen, die aus koaxialen Semi-Rigid-Leitungen hergestellt sind, zu verwenden. Demgegenüber ist es aus T. Zelder, H. Eul, "Contactless network analysis with improved dynamic range using diversity calibration", Proceedings of the 36th European Microwave Conference, Manchester, UK, Seiten 478 bis 481, September 2006 oder T. Zelder, H. Rabe, H. Eul, "Contactless electromagnetic measuring System using conventional calibration algorithms to determine scattering parameters", Advances in Radio Science - Kleinheubacher Berichte 2006, Band 5, 2007 bekannt, ausschließlich kapazitive Sonden in den kontaktlosen Messsystemen zu verwenden. Aus T. Zelder, I. Rolfes, H. Eul, "Contactless vector network analysis using diversity calibration with capacitive and inductive coupled probes", Advances in Radio Science - Kleinheubacher Berichte 2006, Band 5, 2007 sowie J. Stenarson, K. Yhland, C. Wingqvist, "An in-circuit noncontacting measurement method for S-parameters and power in planar circuits", IEEE Transactions on Microwave Theory and Techniques, Band 49, Nr. 12, Seiten 2567 bis 2572, Dezember 2001 sind Messsysteme bekannt, die mit einer Kombination aus kapazitiven und induktiven Sonden realisiert sind.

Obwohl die kontaktlose Vektornetzwerkanalyse das Potenzial hat, kontaktlos Bauteile zu charakterisieren, wurde bislang keine kontaktlose Streuparametermessung von innerhalb einer Schaltung eingebetteten HF- und Mikrowellenkomponenten durchgeführt. Wenn innerhalb einer Schaltung gemessen werden soll, müssen die Positionen der kontaktlosen Sonden während und nach der Kalibrierung verändert werden. Dies bedingt jedoch einen hohen Aufwand, die Messsondenposition während der Messung der Kalibrierstandards und des Testobjektes zu reproduzieren, denn die kleinsten Abweichungen bei der Sondenpositionierung führen bereits zu bedeutend großen Messfehlern.

Der Erfindung liegt die Aufgabe zugrunde, ein kontaktloses Messsystem der o.g. Art derart auszugestalten, dass eine teure und aufwändige Positionierung von Koppelsonden entfallen kann.

Diese Aufgabe wird erfindungsgemäß durch ein Kalibriersubstrat der o.g. Art mit den in Anspruch 1 gekennzeichneten Merkmalen gelöst. Vorteilhafte Ausgestaltungen der Erfindung sind in den weiteren Ansprüchen beschrieben.

Bei einem kontaktlosen Messsystem der o.g. Art ist es erfindungsgemäß vorgesehen, dass auf der Schaltungsplatine wenigstens eine Kontaktstruktur derart ausgebildet und angeordnet ist, dass diese Kontaktstruktur von dem Signal-Wellenleiter galvanisch getrennt ist, einen Teil der Koppelstruktur ausbildet, vollständig im Nahfeld des Signal-Wellenleiters angeordnet ist und wenigstens einen Kontaktpunkt aufweist, der von einem Kontakt einer Messspitze elektrisch kontaktierbar ist.

Dies hat den Vorteil, dass die Kontaktstruktur und damit die gesamte Koppelstruktur eine genau definierte geometrische Anordnung zum Signal-Wellenleiter aufweist, wobei eine manuelle Positionierung der Koppelstruktur entfallen kann. Es wird auf einfache Weise eine reproduzierbare Kopplung zwischen dem Signal-Wellenleiter und der Koppelstruktur erzielt.

Zweckmäßigerweise ist die Kontaktstruktur als Leiterbahn auf der Schaltungsplatine ausgebildet.

Ein besonders gute Signalauskopplung erzielt man dadurch, dass die Kontaktstruktur derart ausgebildet ist, dass diese von einer Messspitze impedanzelektrisch kontrolliert kontaktierbar ist.

Wenigstens eine Kontaktstruktur ist beispielsweise als Koppel-Wellenleiter mit Innenleiter und Außenleiter oder als wenigstens ein Kontaktpunkt oder Kontaktfläche für einen Kontakt einer Messspitze ausgebildet.

Zweckmäßigerweise sind die Kontaktstruktur und/oder der Signal-Wellenleiter als gedruckte Leiterbahnen auf der Schaltungsplatine ausgebildet.

Beispielsweise ist die Schaltungsplatine als gedruckte Schaltungsplatine (PCB) oder Wafer ausgebildet.

Eine optimale Richtdämpfung bzw. ein breitbandig isoliertes Tor erzielt man dadurch, dass die Kontaktstruktur als Wellenleiter ausgebildet ist, wobei das Verhältnis des induktiven zum kapazitiven Koppelfaktor gleich dem Produkt der Wellenwiderstände der einzelnen Wellenleiter der Kontaktstruktur ist.

In einer beispielhaften Ausführungsform weist die Koppelstruktur wenigstens eine, insbesondere zwei, Kontaktstrukturen je Messtor auf.

In einer bevorzugten Ausführungsform ist die Schaltungsplatine eine Mehrlagenplatine mit mehreren Substratlagen, wobei der Signal-Wellenleiter auf einer ersten Substratlage der Mehrlagenplatine und wenigstens eine Kontaktstruktur auf der ersten oder wenigstens einer anderen Substratlage der Mehrlagenplatine ausgebildet ist.

Beispielsweise sind wenigstens zwei der Kontaktstrukturen auf verschiedenen Substratlagen der Mehrlagenplatine angeordnet.

In einer besonders bevorzugten Ausführungsform weist die wenigstens eine Kontaktstruktur Kontaktpunkte auf, welche derart ausgebildet und angeordnet sind, dass eine Kontaktierung mit On-Wafer- oder PCB-Messspitzen einen impedanzkontrollierten Übergang ergibt.

Zur schnellen und einfachen Kalibrierung des kontaktlosen Messsystems ist auf der Schaltungsplatine zusätzliche wenigstens ein Kalibrierelement ausgebildet, welches mit wenigstens einem Signal-Wellenleiter verbunden ist, an dem wenigstens eine Kontaktstruktur derart angeordnet ist, dass die Anordnung der Kontaktstruktur an dem Signal-Wellenleiter eines Kalibrierelementes der Anordnung der Kontakstrukturen an den Signal-Wellenleitern der elektrischen Schaltung entspricht.

Wenigstens ein Kalibrierelement ist mit einer Anzahl von Signal-Wellenleitern verbunden, die der Anzahl von Messtoren des kontaktlosen Messsystems entspricht.

Um an den Kalibrierelementen und der elektrischen Schaltung identische Koppelverhältnisse mit optimaler Kalibrierung herzustellen, ist wenigstens eine einem Messtor des kontaktlosen Messsystems zugeordnete Kontaktstruktur an den Signal-Wellenleitern der Kalibrierelemente identisch ausgebildet wie die wenigstens eine diesem Messtor des kontaktlosen Messsystems zugeordnete Kontaktstruktur an den Signal-Wellenleitern der elektrischen Schaltung.

Bei einem Kalibriersubstrat der o.g. Art ist es erfindungsgemäß vorgesehen, dass das Kalibriersubstrat als Schaltungsplatine ausgebildet ist, auf dem wenigstens eine Kontaktstruktur derart ausgebildet und angeordnet ist, dass diese Kontaktstruktur von dem Signal-Wellenleiter galvanisch getrennt ist, einen Teil der Koppelstruktur ausbildet, vollständig im Nahfeld des Signal-Wellenleiters angeordnet ist und wenigstens einen Kontaktpunkt aufweist, der von einem Kontakt einer Messspitze elektrisch kontaktierbar ist.

Dies hat den Vorteil, dass die Kontaktstruktur und damit die gesamte Koppelstruktur eine genau definierte geometrische Anordnung zum Signal-Wellenleiter aufweist, wobei eine manuelle Positionierung der Koppelstruktur entfallen kann. Es wird auf einfache Weise eine reproduzierbare Kopplung zwischen dem Signal-Wellenleiter und der Koppelstruktur erzielt.

Das kontaktlose Messsystem ist bevorzugt wie zuvor beschrieben ausgebildet, wobei es hierbei besonders bevorzugt ist, dass wenigstens eine einem Messtor des kontaktlosen Messsystems zugeordnete Kontaktstruktur an den Signal-Wellenleitern der Kalibrierelemente identisch ausgebildet ist wie die wenigstens eine diesem Messtor des kontaktlosen Messsystems zugeordnete Kontaktstruktur an den Signal-Wellenleitern der elektrischen Schaltung.

Wenigstens ein Kalibrierelement ist mit einer Anzahl von Signal-Wellenleitern verbunden, die der Anzahl von Messtoren des kontaktlosen Messsystems entspricht.

Zweckmäßigerweise ist auf der Schaltungsplatine des Kalibriersubstrates wenigstens eine elektrische Schaltung mit wenigstens einem Signal-Wellenleiter ausgebildet, an dem wenigstens eine Kontaktstruktur derart angeordnet ist, dass die Anordnung der Kontaktstruktur an dem Signal-Wellenleiter der elektrischen Schaltung der Anordnung der Kontaktstrukturen an den Signal-Wellenleitern eines Kalibrierelementes entspricht.

In einer bevorzugten Ausführungsform ist wenigstens eine einem Messtor des kontaktlosen Messsystems zugeordnete Kontaktstruktur an den Signal-Wellenleitern der Kalibrierelemente identisch ausgebildet wie die wenigstens eine diesem Messtor des kontaktlosen Messsystems zugeordnete Kontaktstruktur auf dem Kalibriersubstrat an den Signal-Wellenleitern der elektrischen Schaltung.

Die Erfindung wird im Folgenden anhand der Zeichnung näher erläutert. Diese zeigt in:
- Fig. 1: ein schematisches Blockschaltbild einer bevorzugten Ausführungsform eines erfindungsgemäßen kontaktlosen Messsystems mit einem vektoriellen Netzwerkanalysator,
- Fig. 2: eine erste bevorzugte Ausführungsform einer Kontaktstruktur für das erfindungsgemäße kontaktlose Messsystem,
- Fig. 3: eine zweite bevorzugte Ausführungsform einer Kontaktstruktur für das erfindungsgemäße kontaktlose Messsystem und
- Fig. 4: eine erste bevorzugte Ausführungsform eines erfindungsgemäßen Kalibriersubstrats für das erfindungsgemäße kontaktlose Messsystem in Draufsicht,
- Fig. 5: eine beispielhafte, alternative Ausführungsform einer Kontaktstruktur für das erfindungsgemäße kontaktlose Messsystem,
- Fig. 6: eine weitere beispielhafte, alternative Ausführungsform einer Kontaktstruktur für das erfindungsgemäße kontaktlose Messsystem,
- Fig. 7: eine weitere beispielhafte, alternative Ausführungsform einer Kontaktstruktur für das erfindungsgemäße kontaktlose Messsystem,
- Fig. 8: eine weitere beispielhafte, alternative Ausführungsform einer Kontaktstruktur für das erfindungsgemäße kontaktlose Messsystem,
- Fig. 9: eine weitere beispielhafte, alternative Ausführungsform einer Kontaktstruktur für das erfindungsgemäße kontaktlose Messsystem,
- Fig. 10: eine weitere beispielhafte, alternative Ausführungsform einer Kontaktstruktur für das erfindungsgemäße kontaktlose Messsystem,
- Fig. 11: eine weitere beispielhafte, alternative Ausführungsform einer Kontaktstruktur für das erfindungsgemäße kontaktlose Messsystem,
- Fig. 12: eine weitere beispielhafte, alternative Ausführungsform einer Kontaktstruktur für das erfindungsgemäße kontaktlose Messsystem,
- Fig. 13: eine weitere beispielhafte, alternative Ausführungsform einer Kontaktstruktur für das erfindungsgemäße kontaktlose Messsystem,
- Fig. 14: eine zweite bevorzugte Ausführungsform eines erfindungsgemäßen Kalibriersubstrats für das erfindungsgemäße kontaktlose Messsystem in Draufsicht und
- Fig. 15: eine dritte bevorzugte Ausführungsform eines erfindungsgemäßen Kalibriersubstrats für das erfindungsgemäße kontaktlose Messsystem in Draufsicht.

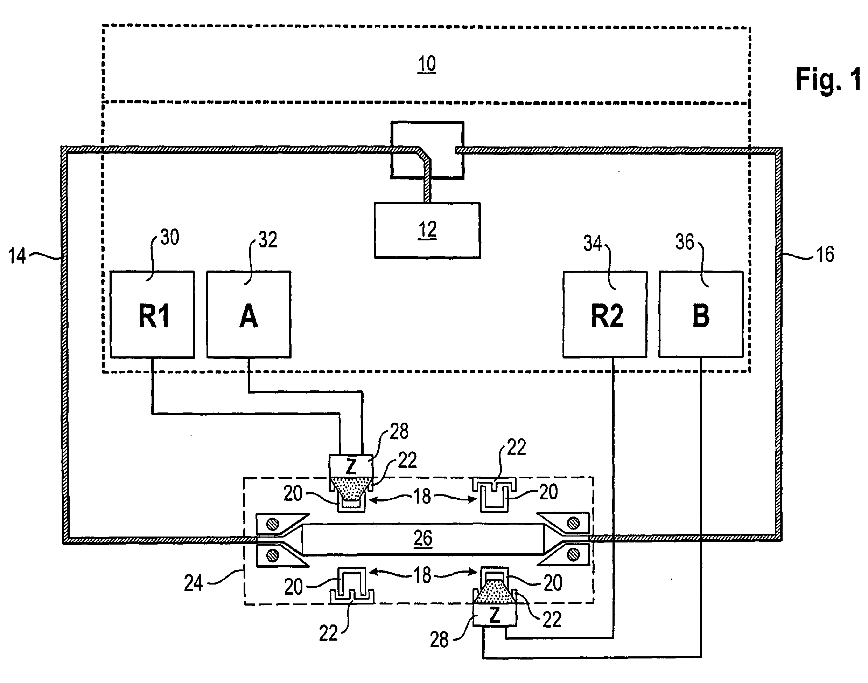

Die in Fig. 1 dargestellte, bevorzugte Ausführungsform eines erfindungsgemäßen kontaktlosen Messsystems umfasst einen vektoriellen Netzwerkanalysator 10 mit einer Signalquelle 12, Signalleitern 14 und 16 und einer Kontaktstruktur mit vier Koppel-Wellenleitern 18, die jeweils einen Innenleiter 20 und einen Außenleiter 22 aufweisen. Die Koppel-Wellenleiter 18 sind als gedruckte Leiterbahnen auf einer gedruckten Schaltungsplatine 24 ausgebildet. Weiterhin ist auf dieser gedruckten Schaltungsplatine 24 ein Signal-Wellenleiter 26 als gedruckte Leiterbahn ausgebildet. Der Signal-Wellenleiter 26 ist Teil einer ansonsten nicht näher dargestellten, auf der gedruckten Schaltungsplatine 26 ausgebildeten elektronischen Schaltung mit entsprechenden elektronischen Bauelementen.

Die Koppel-Wellenleiter 18 bilden jeweils zusammen mit einer Messspitze 28 eine Kopplungsstruktur für das kontaktlose Messsystem aus, um eine auf dem Signal-Wellenleiter 26 laufende, elektromagnetische Welle kontaktlos auszukoppeln. Die Messspitzen 28 stellen einerseits einen elektrischen Kontakt mit jeweils einem Koppel-Wellenleiter 18 und andererseits mit den Messtoren 30, 32, 34, 36 des vektoriellen Netzwerkanalysators 10 her.

Die Koppel-Wellenleiter 18 können nahezu beliebig geformt sein. Es ist besonders vorteilhaft, die Koppel-Wellenleiter 18 impedanzkontrolliert auszubilden, d.h. die charakteristischen Wellenwiderstände der Anordnung sind bekannt und auf Reflexionsarmut optimiert. Der Vorteil einer impedanzkontrollierten Kontaktstruktur liegt darin, dass eine optimale Richtdämpfung bzw. ein breitbandig isoliertes Tor erzielt werden kann.

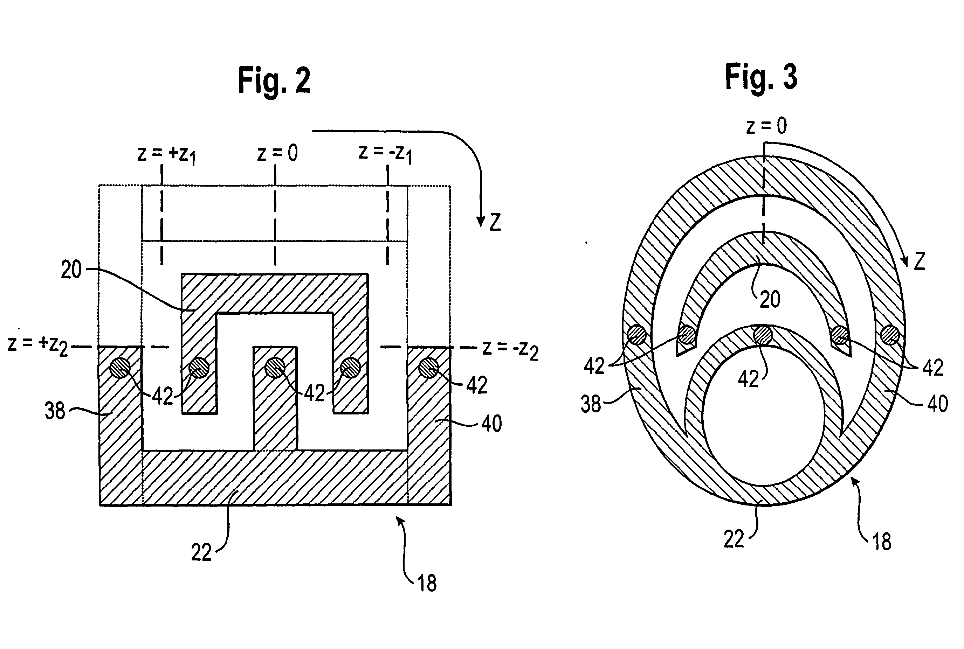

Zwei Beispiele eines derartigen impedanzkontrollierten Koppel-Wellenleiters 18 zeigen die Fig. 2 und 3. Der in Fig. 2 dargestellte Koppel-Wellenleiter 18 umfasst den U-förmigen Innenleiter 20 und den Außenleiter 22. Der Außenleiter 22 kann dabei verschieden ausgeführt sein. Zum einen kann der Außenleiter 22 geschlossen sein, d.h. Außenleiterarme 38 und 40 schließen sich an der Koordinate z = 0, wie in Fig. 2 mit gestrichelten Linien angedeutet, und zum anderen können die Enden der Außenleiterarme 38, 40 entlang z getrennt sein. Beispielsweise enden dann die Arme 38, 40 an den Positionen +Z₁ und -Z₁ oder, wie in Fig. 2 dargestellt, an den Positionen +Z₂ und -Z₂. Durch die Anordnung des Außenleiters 22 zum Innenleiter 20 entspricht der Koppel-Wellenleiter 18 einer gebogenen Koplanarleitung. Es sind verschiedene Varianten dieser Koppel-Wellenleiter 18 möglich. Eine eckenlose Variante ist in Fig. 3 dargestellt. Hierbei sind beispielhaft die beiden Außenleiterarme 38 und 40 an der Position z = 0 miteinander verbunden.

Ein weiterer Vorteil der erfindungsgemäßen Kontaktstruktur ist, dass keine Durchkontaktierungen gegen Masse (rückwärtige Grundmetallisierung der Schaltungsplatine 24) notwendig sind. Jedoch ist die Möglichkeit, die Außenleiter 22 der Koppel-Wellenleiter 18 mittels Durchkontaktierungen mit Masse zu verbinden, nicht eingeschränkt.

Für die Energieauskopplung von dem Signal-Wellenleiter 26 eines Testobjektes (DUT - Devide Under Test) wird jeweils mindestens eine Kontaktstruktur bzw. Koppel-Wellenleiter 18 in das Nahfeld des jeweiligen Signal-Wellenleiters 26 gebracht. Dabei kann sich der Koppel-Wellenleiter 18 auf demselben Substrat wie der jeweilige Signal-Wellenleiter 26, aber auch bei einer Mehrlagenplatine auf einem anderen Substrat befinden. Die Kontaktstruktur mit den Koppel-Wellenleitern 18 wird dann beispielsweise mit einer kommerziellen symmetrischen On-Wafer- oder PCB-Messspitze verbunden. Das Bezugszeichen 42 kennzeichnet in Fig. 2 und 3 die Kontaktpositionen der Kontakte von Messspitzen mit der Kontaktstruktur bzw. dem jeweiligen Koppel-Wellenleiter 18. Zur Charakterisierung eines N-Tor-Testobjektes sind mindestens N Koppel-Wellenleiter 18 notwendig, die sich im Nahfeld der N Signal-Wellenleiter 26 befinden. In Fig. 1 ist als Beispiel ein 2-Tor-Testobjekt (hier einfache Leitung = DUT) mit vier Koppel-Wellenleiter 18 dargestellt.

Die Geometrie der Koppel-Wellenleiter 18 und der Messspitze 28 beeinflussen beide den Koppelfaktor der Anordnung. Die Messspitzen 28 werden mit (vektoriellen) Empfängern beispielsweise eines herkömmlichen Netzwerkanalysators verbunden, wie in Fig. 1 dargestellt.

Das Messverfahren zum Messen mit Hilfe mindestens einer impedanzkontrollierten Kontaktstruktur oder mindestens einer nicht impedanzkontrollierten Kontaktstruktur innerhalb von planaren Schaltungen eingebetteter Messobjekte wird im Folgenden beschrieben.

Das Verfahren beruht grundsätzlich auf dem Verfahren der kontaktlosen Vektornetzwerkanalyse. Der Nachteil der kontaktlosen Vektornetzwerkanalyse ist, dass die Anwendung des Verfahrens zum Erzielen genauer Messwerte sehr stark von der Positioniergenauigkeit der kontaktlosen Messsonden abhängt. Erfindungsgemäß ist es nunmehr vorgesehen, gedruckte Kontaktstrukturen in Kombination mit herkömmlichen Messspitzen, anstatt eines aufwändigen automatischen Positioniersystems in Kombination mit vollständigen kontaktlosen Sonden, zu verwenden. Dabei müssen alle Signalzuleitungen der Testobjekte und der Kalibrierelemente, die für eine Systemfehlerkalibrierung notwendig sind, mit mindestens einem Koppel-Wellenleiter 18 (Kontaktstruktur) versehen werden.

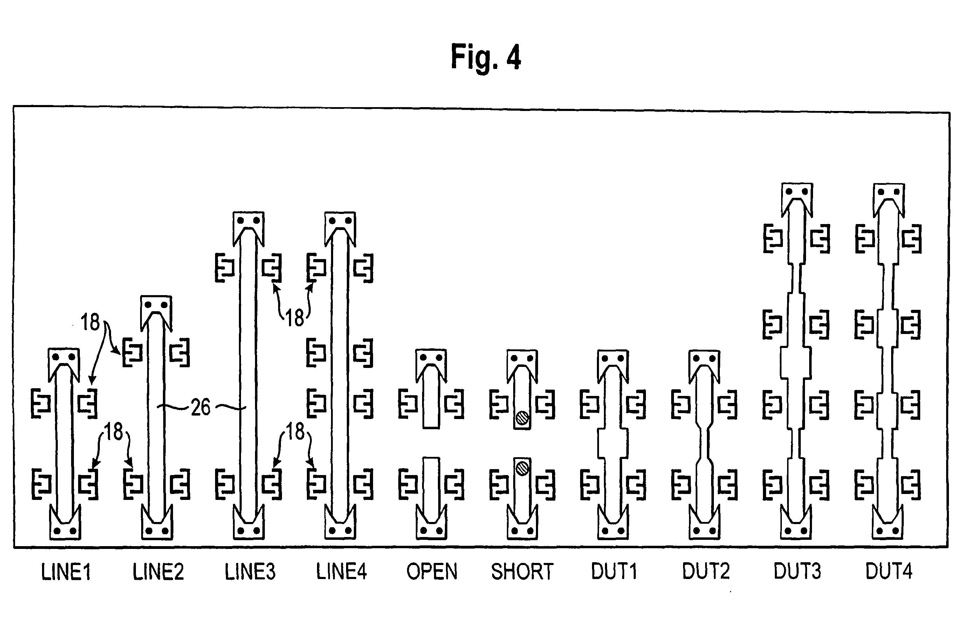

Ein Beispiel für eine praktische Realisierung eines Kalibriersubstrates mit eingebetteten Testobjekten (DUT3, DUT4) unter Verwendung von Kontaktstrukturen mit gedruckten Koppel-Wellenleiter 18 ist in Fig. 4 dargestellt. Für eine 2-Tor-Kalibrierung umfasst die Kontaktstruktur für jeden Signal-Wellenleiter 26 jeweils zwei Koppel-Wellenleiter 18, welche beispielsweise gemäß der Ausführungsform nach Fig. 2 ausgebildet sind. Für eine N-Tor-Kalibrierung ist eine Kontaktstruktur mit mindestens N Koppel-Wellenleiter 18 je Signal-Wellenleiter 26 notwendig. Bei der Verwendung eines Diversitätskalibrierverfahrens ist es auch sinnvoll eine Kontaktstruktur mit mehr als N Koppel-Wellenleitern 18 je Signal-Wellenleiter 26 zu verwenden.

Aufgrund der kleinen Dimensionen der Koppel-Wellenleiter 18 können beispielsweise On-Wafer- oder PCB-Messspitzen reproduzierbar auf die identischen Koppel-Wellenleiter 18 der einzelnen Kalibrierelemente (LINE1, LINE2, LINE3, LINE4, OPEN, SHORT) positioniert werden. Nach dem das System kalibriert worden ist, können beispielsweise die Streuparameter von eingebetteten Bauteilen bestimmt werden. Jedoch müssen die Signalleitungen der Bauteile die gleichen Eigenschaften besitzen (Geometrie, Wellenwiderstand, etc.) wie die der Kalibrierelemente. Zudem muss auf der planaren Schaltung an jedem Signal-Wellenleiter 26 des eingebetteten Testobjektes (DUT) die gleiche Kontaktstruktur, die auch bei der Kalibrierung verwendet wird, vorhanden sein.

Das Verfahren beinhaltet also die Platzierung einer Kontaktstruktur beispielsweise in Form eines Koppel-Wellenleiters 18 im Nahfeld des Signal-Wellenleiters 26 der Kalibrier- und Testobjekte auf einer Schaltungsplatine 24. Die Koppel-Wellenleiter 18 sind dabei auf der Schaltungsplatine 24 derart angeordnet und ausgebildet, dass sie zum einen die Funktion einer Schaltung kaum stören und zum anderen mit beispielsweise herkömmlichen On-Wafer- bzw. PCB-Messspitzen verschaltet werden können.

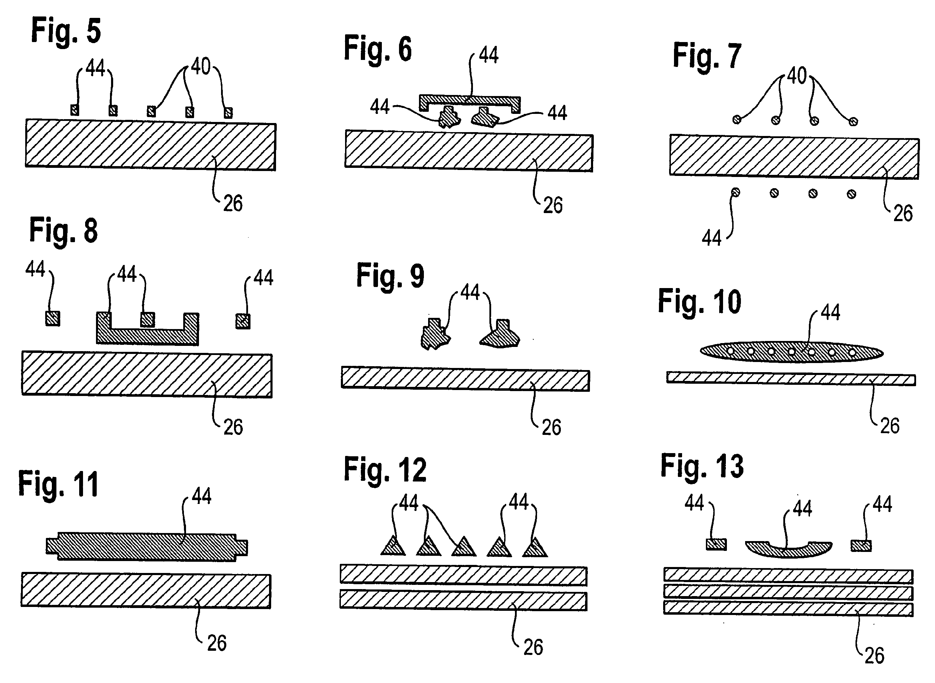

Die Fig. 5 bis 13 veranschaulichten verschiedene beispielhafte Ausführungsformen für Kontaktstrukturen 44. Die Kontaktstrukturen 44 können sehr spezielle Formen haben. Prinzipiell ist eine beliebige Form verwendbar. Um eine reproduzierbare Kopplung zwischen dem Signal-Wellenleiter 26 und dem Koppel-Wellenleiter 18 oder dem Signal-Wellenleiter 26 und der Messsonde 28 oder dem Signal-Wellenleiter 26 und dem Koppel-Wellenleiter 18 und der Messsonde 28 herzustellen, besitzt die Kontaktstruktur 44, wenn sie aus eine materielle Fläche umfasst, entweder Löcher, in die die Messspitze positioniert wird, oder eine markante Geometrie auf die die Messspitze positioniert wird. Alternativ kann die Kontaktstruktur 44 auch als Einkerbung im Substrat ausgebildet sein.

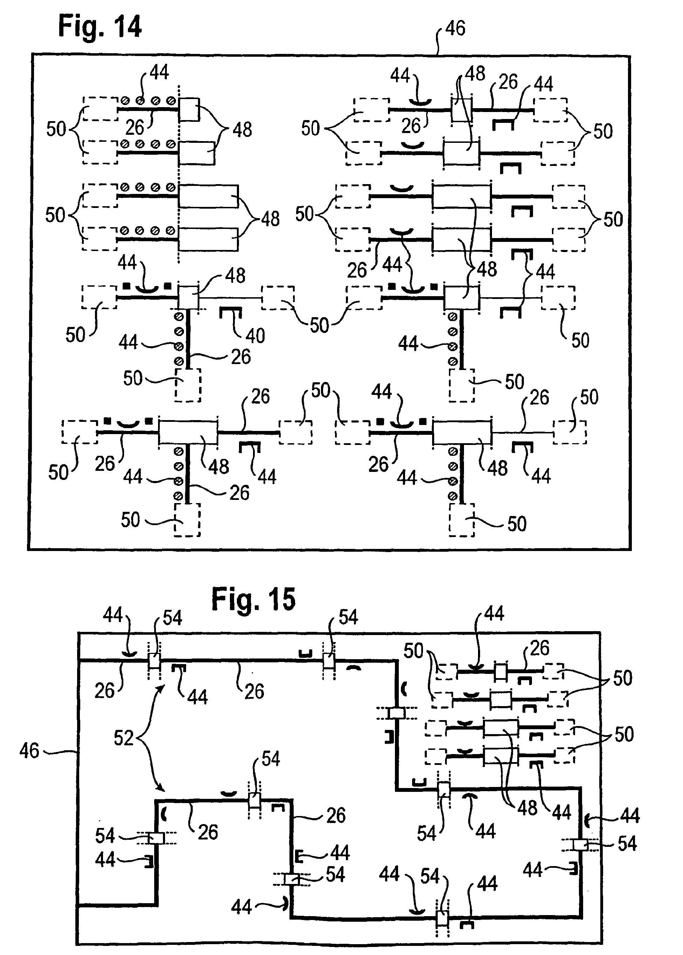

Fig. 14 zeigt eine zweite bevorzugte Ausführungsform eines erfindungsgemäßen Kalibriersubstrates, welches auf einer Schaltungsplatine 46 ausgebildet ist. Funktionsgleiche Teile sind mit gleichen Bezugszeichen bezeichnet, wie in Fig. 1 und 4, so dass zu deren Erläuterung auf die obige Beschreibung der Fig. 1 und 4 verwiesen wird. Auf dem Kalibriersubstrat sind mehrer Kalibrierelemente 48 angeordnet und jedes Kalibrierelement 48 ist mit einem, zwei oder drei Signal-Wellenleitern 26 verbunden. An den Signal-Wellenleitern 26 sind anders als bei der ersten Ausführungsform gemäß Fig. 4, keine Koppel-Wellenleiter, sondern Kontaktstrukturen 44 wie in Fig. 5 bis 13 dargestellt, ausgebildet. An entsprechenden Kontaktstellen 50 werden wahlweise Signale auf die Signal-Wellenleiter 26 gegeben. Dieses Kalibriersubstrat umfasst verschiedene 1-Tor-, 2-Tor- und 3-Tor-Kalibrierstandards 48 und verschiedene Kontaktstrukturen 44.

Fig. 15 zeigt eine dritte bevorzugte Ausführungsform eines erfindungsgemäßen Kalibriersubstrates, welches auf einer Schaltungsplatine 46 ausgebildet ist. Funktionsgleiche Teile sind mit gleichen Bezugszeichen bezeichnet, wie in Fig. 1, 4 und 14, so dass zu deren Erläuterung auf die obige Beschreibung der Fig. 1, 4 und 14 verwiesen wird. Bei dieser Ausführungsform ist zusätzlich eine elektronische Schaltung 52 mit zu testenden Bauteilen 54 (DUTs) auf der Schaltungsplatine 46 des Kalibriersubstrates ausgebildet. Umgekehrt kann man auch sagen, dass auf der Schaltungsplatine 46 mit der elektronischen Schaltung 52 zusätzlich Kalibrierelemente 48 angeordnet sind. Die Kontaktstruktur 44 für ein bestimmtes Messtor an den Signal-Wellenleitern 26 der Kalibrierelemente sind identisch ausgebildet wie die Kontaktstruktur 44 für dieses Messtor an den Signal-Wellenleitern 26 der elektronische Schaltung 52.

Für die richtige Messung der Streuparameter eines N-Tores muss das Messsystem kalibriert werden. Je nach Kalibrierung werden M verschiedene N-Tor-Kalibrierstandards (Kalibrierelemente 48), die bekannt oder nur teilweise bekannt sind, benötigt. Für eine Kalibrierung unter Verwendung von M Kalibrierstandards müssen die Geometrie und die Position der Kontaktstruktur und der Signal-Wellenleiter 26 jeweils für ein Messtor identisch sein, können aber zwischen den N-Messtoren unterschiedlich sein.

Sollen beispielsweise die Streuparameter eines 2-Tor-Objektes gemessen werden, sind für eine LLR-Kalibrierung drei 2-Tor-Kalibrierstandards notwendig. Dies können zum Beispiel zwei unterschiedlich lange Leitungen und zwei Kurzschlüsse sein, wobei die Kurzschlüsse jeweils ein 1-Tor-Objekt darstellen, aber zusammen einem 2-Tor-Objekt entsprechen. Die drei 2-Tor-Standards können je Tor zwei unterschiedliche Zuleitungen (Signal-Wellenleiter 26) besitzen. Die Kontaktstruktur 44 können ebenfalls an jeder Zuleitung (jedem Signal-Wellenleiter 26) unterschiedlich in der Position und der Geometrie sein. Jedoch müssen die Signal-Wellenleiter 26 und die Kontaktstruktur 44 an den jeweiligen Toren 1 der Kalibrierstandards und DUTs 48 identisch sein. Auch am Tor 2 der Kalibrierstandards müssen die Signal-Wellenleiter 26 und die Kontaktstruktur 44 untereinander übereinstimmen, jedoch können sie sich zu denen am Tor 1 unterscheiden.

## Patentansprüche

1. Kalibriersubstrat für ein kontaktloses Messsystem, mit wenigstens einer Messspitze, die einen Teil einer Koppelstruktur zum kontaktlosen Auskoppeln eines auf einem Signal-Wellenleiter (26) laufenden Signals ausbildet, wobei auf dem Kalibriersubstrat wenigstens ein Kalibrierelement (48), insbesondere Kurzschluss-Standard, Leerlauf-Standard, Widerstands-Standard, Leitungs-Standard, ausgebildet ist, wobei das wenigstens eine Kalibrierelement elektrisch mit wenigstens einem Signal-Wellenleiter (26), insbesondere Mikrostreifenleitung oder Koplanarleitung, verbunden ist, **dadurch gekennzeichnet, dass** das Kalibriersubstrat als Schaltungsplatine (46) ausgebildet ist, auf dem wenigstens eine Kontaktstruktur (44) derart ausgebildet und angeordnet ist, dass diese Kontaktstruktur (44) von dem Signal-Wellenleiter (26) galvanisch getrennt ist, einen Teil der Koppelstruktur ausbildet, vollständig im Nahfeld des Signal-Wellenleiters (26) angeordnet ist und wenigstens einen Kontaktpunkt (42) aufweist, der von einem Kontakt einer Messspitze (28) elektrisch kontaktierbar ist.

2. Kalibriersubstrat nach Anspruch 1, **dadurch gekennzeichnet, dass** wenigstens ein Kalibrierelement (48) mit einer Anzahl von Signal-Wellenleitern (26) verbunden ist, die der Anzahl von Messtoren des kontaktlosen Messsystems entspricht.

3. Kalibriersubstrat nach wenigstens einem der beiden Ansprüche 1 oder 2, **dadurch gekennzeichnet, dass** auf der Schaltungsplatine (46) des Kalibriersubstrates wenigstens eine elektrische Schaltung (52) mit wenigstens einem Signal-Wellenleiter (26) ausgebildet ist, an dem wenigstens eine Kontaktstruktur (44) derart angeordnet ist, dass die Anordnung der Kontaktstruktur (44) an dem Signal-Wellenleiter (26) der elektrischen Schaltung (52) der Anordnung der Kontaktstrukturen (44) an den Signal-Wellenleitern (26) eines Kalibrierelementes (44) entspricht.

4. Kalibriersubstrat nach Anspruch 3, **dadurch gekennzeichnet, dass** wenigstens eine einem Messtor des kontaktlosen Messsystems zugeordnete Kontaktstruktur (44) an den Signal-Wellenleitern (26) der Kalibrierelemente (48) identisch ausgebildet ist wie die wenigstens eine diesem Messtor des kontaktlosen Messsystems zugeordnete Kontaktstruktur (44) auf dem Kalibriersubstrat an den Signal-Wellenleitern (26) der elektrischen Schaltung (52).

## Claims

1. Calibration substrate for a contactless measuring system, comprising at least one probe tip which comprises part of a coupling structure for contactless extraction of a signal travelling along a signal waveguide (26), wherein at least one calibration element (48) is provided on the calibration substrate, in particular a short-circuit standard, an open circuit standard, a resistance standard or a conductor standard, wherein the at least one calibration element is electrically connected to at least one signal waveguide (26), particularly a microstrip line or a coplanar line, **characterised in that** the calibration substrate is configured as a circuit board (46) on which at least one contact structure (44) is configured and arranged such that said contact structure (44) is galvanically isolated from the signal waveguide (26), and comprises part of the coupling structure, is entirely arranged in the near field region of the signal waveguide (26) and comprises at least one contact point (42) which is electrically contactable by a contact of a probe tip (28).

2. Calibration substrate according to claim 1, **characterised in that** at least one calibration element (48) is connected to a number of signal waveguides (26) which corresponds to the number of measurement ports of the contactless measuring system.

3. Calibration substrate according to one of the claims 1 or 2, **characterised in that** arranged on the circuit board (46) of the calibration substrate is at least one electrical circuit (52) comprising at least one signal waveguide (26), at which at least one contact structure (44) is arranged such that the arrangement of the contact structure (44) at the signal waveguide (26) of the electrical circuit (52) corresponds to the arrangement of the contact structures (44) at the signal waveguides (26) of a calibration element (44).

4. Calibration substrate according to claim 3, **characterised in that** at least one contact structure (44) allocated to a measurement port of the contactless measuring system and arranged at the signal waveguides (26) of the calibration elements (48) is configured identically to the at least one contact structure (44) allocated to said measurement port of the contactless measurement system and arranged on the calibration substrate at the signal waveguides (26) of the electrical circuit (52).

## Revendications

1. Substrat de calibrage pour un système de mesure sans contact, comprenant au moins une pointe de mesure, qui forme une partie d'une structure de couplage pour le découplage sans contact d'un signal circulant sur un guide d'onde de signal (26), dans lequel sur le substrat de calibrage est formé au moins un élément de calibrage (48), en particulier court-circuit standard, circuit de marche à vide standard, résistance standard, ligne standard, dans lequel ledit au moins un élément de calibrage est connecté électriquement à au moins un guide d'onde de signal (26) en particulier une ligne à microbande ou une ligne coplanaire,
**caractérisé en ce que** le substrat de calibrage est réalisé sous la forme d'une platine à circuit (46) sur laquelle au moins une structure de contact (44) est réalisée et agencée de telle façon que cette structure de contact (44) est séparée sur le plan galvanique depuis le guide d'onde de signal (26), constitue une partie de la structure de couplage, est agencée entièrement dans le champ proche du guide d'onde de signal (26) et comprend au moins un point de contact (42) qui peut être mis en contact électrique avec un contact d'une pointe de mesure (28).

2. Substrat de calibrage selon la revendication 1, **caractérisé en ce qu'**au moins un élément de calibrage (48) est connecté à un nombre de guides d'ondes de signaux (26) qui correspond au nombre des portes de mesure du système de mesure sans contact.

3. Substrat de calibrage selon l'une au moins des deux revendications 1 ou 2, **caractérisé en ce que** sur la platine à circuit (46) du substrat de calibrage est réalisé au moins un circuit électrique (52) avec au moins un guide d'onde de signal (26), sur lequel est agencée au moins une structure de contact (44) de telle manière que l'agencement de la structure de contact (44) sur le guide d'onde de signal (26) du circuit électrique (52) correspond à l'agencement des structures de contact (44) sur les guides d'onde de signaux (26) d'un élément de calibrage (44).

4. Substrat de calibrage selon la revendication 3, **caractérisé en ce qu'**au moins une structure de contact (44), associée à une porte de mesure du système de mesure sans contact, est réalisée sur les guides d'onde de signaux (26) des éléments de calibrage (48) identiquement à ladite au moins une structure de contact (44), associée à cette porte de mesure du système de mesure sans contact, sur le substrat de calibrage sur les guides d'onde de signaux (26) du circuit électrique (52).
